# EUROPEAN PATENT APPLICATION

(11) **EP 4 660 645 A1**
(43) Date of publication of application: **10.12.2025**
(21) Application number: 24767319.7
(22) Date of filing: 26.02.2024
(51) Int. Cl.: G01R 31/367, G01R 31/396, G01R 31/392, G06N 3/08

(54) **DEVICE FOR DETERMINING COMPONENT STATE ACCORDING TO COMPONENT TYPE AND OPERATING METHOD THEREOF**

(30) Priority: 06.03.2023 KR 20230029521
(71) Applicant: LG Energy Solution, Ltd., Seoul 07335 (KR)
(72) Inventor: KIM, Jin Young, Daejeon 34122 (KR); MIN, Kyoung Choon, Daejeon 34122 (KR)
(74) Representative: BCKIP Part mbB
(86) International application number: PCT/KR2024/002452
(87) International publication number: WO 2024/186030

(57) **Abstract**

An apparatus for determining a state of a component according to one embodiment disclosed herein may include a data acquisition unit configured to acquire performance data about one or more components included in an electronic device, a data extraction unit configured to extract first performance data about a first component of which a replacement time has not been determined in advance among the performance data, and a determination unit configured to determine a state of the first component using a pre-learned first artificial intelligence (AI) model based on the first performance data, wherein the first AI model may be learned based on a plurality of reference data sets according to a degree of degradation of the first component, and learned to reduce a difference between actual performance of the first component and predicted performance output from the first AI model.

## Description

### [Technical Field]

### CROSS-REFERENCE TO RELATED APPLICATION

This application claims priority to and the benefit of Korean Patent Application No. 10-2023-0029521 filed in the Korean Intellectual Property Office on March 6, 2023, the entire contents of which are incorporated herein by reference.

### TECHNICAL FIELD

Embodiments disclosed herein relate to an apparatus for determining a state of a component according to the type of component, and a method of operating the same.

### [Background Art]

Recently, research and development on secondary batteries has been actively conducted. Here, the secondary battery is a battery capable of charging and discharging and includes all recent lithium ion batteries such as conventional Ni/Cd batteries and Ni/MH batteries. Among the secondary batteries, lithium-ion batteries have an advantage of having much higher energy density than conventional Ni/Cd batteries and Ni/MH batteries. In addition, the lithium-ion batteries may be made smaller and lighter and thus are used as a power source for mobile devices and recently, are attracting attention as next-generation energy storage media due to the expansion of the range of usage to a power source for electric vehicles.

A plurality of facilities are present in the process of manufacturing these secondary batteries. As the process of manufacturing the secondary batteries proceeds, components constituting each facility can be degraded. When the component is degraded, it may lead to a failure of the component, and a facility including the corresponding component cannot be used due to a failure of the component. Therefore, there is a need for a technology of determining states of a plurality of components and predicting a replacement time in advance.

### [Disclosure]

### [Technical Problem]

There is a predictive maintenance technology of diagnosing and maintaining whether a plurality of facilities fail in advance. Here, the predictive maintenance technology may check the state of the facility and predict a future state of the facility. With the use of an artificial intelligence (AI)-based predictive maintenance technology of combining AI and predictive maintenance, it is possible to more accurately predict states of components.

However, since a conventional AI-based predictive maintenance technology learns an AI model using a learning data set which does not consider the type of a component, there is a problem in that it is not possible to accurately predict states of components with unclear failure criteria.

In addition, since the conventional AI-based predictive maintenance technology learns the AI model using a learning data set which does not consider the degradation of the component, there is a problem in that it is not possible to accurately predict the states of components of which a replacement cycle depends on degradation.

The objects of embodiments disclosed herein are not limited to the above-described objects, and other objects that are not mentioned will be able to be clearly understood by those skilled in the art from the following descriptions.

### [Technical Solution]

An apparatus for determining a state of a component according to one embodiment disclosed herein may include a data acquisition unit configured to acquire performance data about one or more components included in an electronic device, a data extraction unit configured to extract first performance data about a first component of which a replacement time has not been determined in advance among the performance data, and a determination unit configured to determine a state of the first component using a pre-learned first artificial intelligence (AI) model based on the first performance data, wherein the first AI model may be learned based on a plurality of reference data sets according to a degree of degradation of the first component, and learned to reduce a difference between actual performance of the first component and predicted performance output from the first AI model.

In one embodiment, the first AI model may be learned sequentially using the plurality of reference data sets based on a rolling window technique.

In one embodiment, the degree of degradation may be set by at least one of a driving time and driving environment of the first component.

In one embodiment, the data extraction unit may further extract second performance data of a second component of which a replacement cycle has been determined in advance among the performance data, and the determination unit may determine a state of the second component using a second AI model based on the second performance data.

In one embodiment, the second AI model may be learned so that solution average performance is greater than or equal to required performance based on performance evaluation by a k-fold cross validation technique.

A method of operating an apparatus for determining a state of a component according to one embodiment disclosed herein may include an operation of acquiring performance data about one or more components included in an electronic device, an operation of extracting first performance data about a first component of which a replacement time has not been determined in advance among the performance data, and an operation of determining a state of the first component using a pre-learned first artificial intelligence (AI) model based on the first performance data, wherein the first AI model may be learned based on a plurality of reference data sets according to a degree of degradation of the first component, and learned to reduce a difference between actual performance of the first component and predicted performance output from the first AI model.

In one embodiment, the first AI model may be learned sequentially using the plurality of reference data sets based on a rolling window technique.

In one embodiment, the degree of degradation may be set by at least one of a driving time and driving environment of the first component.

In one embodiment, the method may further include an operation of extracting second performance data of a second component of which a replacement cycle has been determined in advance among the performance data, and an operation of determining a state of the second component using a second AI model based on the second performance data.

In one embodiment, the second AI model may be learned so that solution average performance is greater than or equal to required performance based on performance evaluation by a k-fold cross validation technique.

### [Advantageous Effects]

According to the apparatus for determining the state of the component and the method of operating the same according to various embodiments disclosed herein, by classifying the type of component depending on whether the component has been determined to be replaced in advance and using an artificial intelligence (AI) model optimized for each type, it is possible to accurately predict the state of the component not scheduled to be replaced in advance.

According to the apparatus for determining the state of the component and the method of operating the same according to various embodiments disclosed herein, by learning the AI model using the plurality of reference data sets which reflect the degradation due to the driving time and/or driving environment of the component, it is possible to accurately predict the state of the component due to degradation.

The effects of the apparatus for learning the AI model based on the degree of degradation of the component and the method of operating the same according to the disclosure of the document are not limited to the above-mentioned effects, and other effects that are not mentioned can be clearly understood to those skilled in the art according to the disclosure of the document.

### [Description of Drawings]

FIG. 1 is a block diagram of an apparatus for learning an artificial intelligence (AI) model according to one embodiment of the present disclosure.
FIG. 2 shows a result graph in which a first AI model has been learned using a plurality of reference data sets which reflect degradation over time according to one embodiment of the present disclosure.
FIG. 3 shows a result graph in which the first AI model has been learned using the plurality of reference data sets which reflect degradation according to a driving environment according to one embodiment of the present disclosure.
FIG. 4 shows a result graph in which a second AI model has been cross-validated according to a k-fold cross validation technique according to one embodiment of the present disclosure.
FIG. 5 is a flowchart showing a method of operating an apparatus for determining a state of a component according to one embodiment of the present disclosure.

In the description of the drawings, the same or similar reference numerals may be used for the same or similar components.

### [Mode for Invention]

Hereinafter, embodiments of the present invention will be described with reference to the accompanying drawings. However, it should be understood that this is not intended to limit the present invention to specific embodiments and includes various modifications, equivalents, and/or alternatives of the embodiments of the present invention.

It should be understood that the embodiments of the present document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "first," "second," "first," "second," "A," "B," "(a)," or "(b)" may simply be used to distinguish the corresponding component from another and do not limit the corresponding components in another aspect (e.g., importance or order).

When a certain component (e.g., a first component) is described as being "coupled," "connected," or "joined" to another component (e.g., a second component) with or without the terms "functionally" or "communicatively" or "coupled" or "connected," this means that the certain component may be connected to another component directly (e.g., by wire or wirelessly) or indirectly (e.g., through a third component).

A method according to various embodiments disclosed herein may be provided to be included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or a program) of the above-described components may include a single object or a plurality of objects, and some of the plurality of objects may be separately disposed in another component. According to the embodiments disclosed herein, one or more components or operations among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

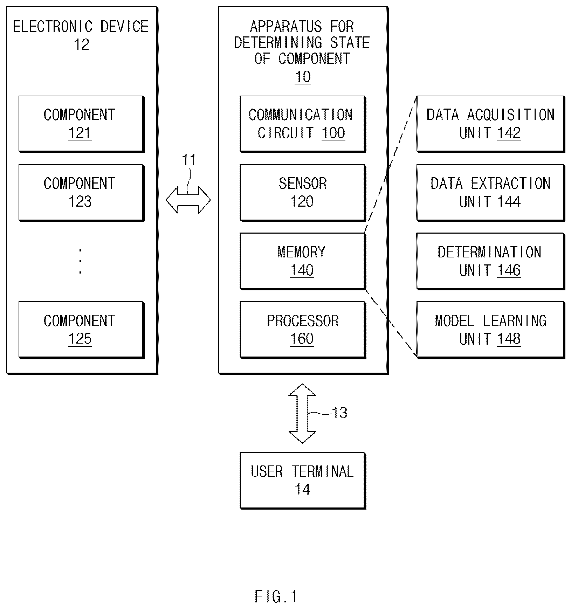

FIG. 1 is a block diagram of an apparatus 10 for determining a state of a component according to one embodiment of the present disclosure.

Referring to FIG. 1, the apparatus 10 for determining the state of the component may be connected to an electronic device 12 and a user terminal 14 in a wired and/or wireless manner.

In one embodiment, a connection 11 between the apparatus 10 for determining the state of the component and the electronic device 12 may be a communication connection via a wired and/or wireless network. In one embodiment, the wired network may be based on local area network (LAN) communication or powerline communication. In one embodiment, the wireless network may be based on a short-range communication network (e.g., Bluetooth, WiFi, or IrDA) or a telecommunication network (a cellular network, a 4G network, or a 5G network).

In another embodiment, the connection 11 between the apparatus 10 for determining the state of the component and the electronic device 12 may be a connection through an inter-device communication method between devices (e.g., a bus, a general purpose input and output (GPIO), a serial peripheral interface (SPI), or a mobile industry processor interface (MIPI)).

In one embodiment, a connection 13 between the apparatus 10 for determining the state of the component and the user terminal 14 may be a communication connection via a wired and/or wireless network.

In one embodiment, the electronic device 12 may be a mobile device (e.g., a mobile phone, a laptop computers, a smart phone, or a smart pad), an electric vehicle (e.g., an electric vehicle (EV), a hybrid EV (HEV), a plug-in HEV (PHEV), or a fuel cell EV (FCEV)), an energy storage system (ESS), or a battery swapping system (BSS).

The following description will be made assuming that the electronic device 12 is an electric vehicle and a plurality of components 121, 123, and 125 are component constituting the electric vehicle. However, it is only a premise for description, and the electronic device 12 of the present disclosure is not limited to the electric vehicle and can be applied to various other devices.

In one embodiment, the user terminal 14 may be a mobile device (e.g., a mobile phone, a laptop computer, a smart phone, or a smart pad) or personal computer (PC).

In one embodiment, the apparatus 10 for determining the state of the component may include a communication circuit 100, a sensor 120, a memory 140, and a processor 160. According to the embodiment, the apparatus 10 for determining the state of the component shown in FIG. 1 may further include at least one component (e.g., a display, an input device, or an output device) other than the components shown in FIG. 1.

In one embodiment, the communication circuit 100 may establish a wired communication channel and/or a wireless communication channel between the apparatus 10 for determining the state of the component and the electronic device 12 and/or the user terminal 14 and transmit and receive data with the electronic device 12 and/or the user terminal 14 through the established communication channel.

In one embodiment, the sensor 120 may detect states of one or more components 121, 123, and 125 constituting the electronic device 12. In one embodiment, data related to the states may indicate one or more data about the type of component, degree of degradation, temperature, or a combination thereof. Here, the type of component may include a consumable component and a non-consumable component. The consumable component may be a component of which a replacement time can be scheduled in advance because failure criteria of the component are clear. For example, the consumable component may be a filter for a vehicle. The non-consumable component may be a component of which a replacement time cannot be scheduled in advance because failure criteria of the component are unclear. For example, the non-consumable component may be a motor or cylinder for a vehicle.

Hereinafter, data related to the performance of the component may be referred to as performance data, the consumable component may be referred to as a first component, and the non-consumable component may be referred to as a second component.

In one embodiment, the memory 140 may include a volatile memory and/or a non-volatile memory.

In one embodiment, the memory 140 may store data used by at least one component (e.g., the processor 160) of the apparatus 10 for determining the state of the component. For example, the data may include software (or instruction related thereto), input data, or output data. In one embodiment, the instruction may allow the apparatus 10 for determining the state of the component to perform operations defined by the instruction when executed by the processor 160.

In one embodiment, the memory 140 may include one or more software (e.g., a data acquisition unit 142, a data extraction unit 144, a determination unit 146, and a model learning unit 148).

In one embodiment, the processor 160 may include a central processing unit, an application processor, a graphics processing unit, a neural processing unit (NPU), an image signal processor, a sensor hub processor, or a communication processor.

In one embodiment, the processor 160 may control at least one another component (e.g., a hardware or software component) of the apparatus 10 for determining the state of the component connected to the processor 160 by executing the software (e.g., the data acquisition unit 142, the data extraction unit 144, the determination unit 146, and the model learning unit 148) and perform various data processing or calculations.

Hereinafter, a method of determining the state of the component using the data acquisition unit 142, the data extraction unit 144, the determination unit 146, and the model learning unit 148 will be described.

The data acquisition unit 142 may acquire performance data. The data acquisition unit 142 may acquire the performance data through the communication circuit 100. The data acquisition unit 142 may acquire performance data about one or more components included in the electronic device 12. The data acquisition unit 142 may acquire performance data about the one or more components included in the electronic device 12 through the communication circuit 100.

The data extraction unit 144 may extract specific data among the performance data. The data extraction unit 144 may classify the performance data according to preset items to extract the specific data. The data extraction unit 144 may classify the performance data into first performance data or second performance data according to the type of component to extract data of a specific item. The data extraction unit 144 may extract the first performance data among the performance data. The data extraction unit 144 may extract the second performance data among the performance data. Here, the first performance data may be performance data for the first component, and the second performance data may be performance data for the second component. However, the items classified by the data extraction unit 144 are not limited to only the first performance data or the second performance data, and the performance data may be classified based on other classification items.

The determination unit 146 may determine the state of the component. The determination unit 146 may determine the state of the component using a previously learned AI model. The determination unit 146 may determine the state of the component using at least one of a previously learned first AI model and a previously learned second AI model. The determination unit 146 may determine a state of the first component using the first AI model and determine a state of the second component using the second AI model.

The model learning unit 148 may learn an AI model. The model learning unit 148 may learn at least one of the first AI model and the second AI model.

### Method of learning first AI model

The model learning unit 148 may generate learning data sets. The model learning unit 148 may generate a plurality of reference data sets for learning the first AI model. The model learning unit 148 may generate the plurality of reference data sets classified according to the degree of degradation of the first component. Here, the degree of degradation may be determined by at least one of a driving time of the first component and a driving environment in which the first component is driven. The driving environment may be an environment in which a facility including the corresponding component is driven. The degrees of degradation of components included in the facility may be changed depending on the type of battery being manufactured. For example, the degree of degradation when the same number of button-type batteries is manufactured during the same period may differ from the degree of degradation when cell-type batteries are manufactured.

The model learning unit 148 may learn the first AI model. The model learning unit 148 may learn the first AI model using the plurality of reference data sets. The model learning unit 148 may learn the first AI model based on a rolling window technique. The model learning unit 148 may learn the first AI model sequentially using the plurality of reference data sets based on the rolling window technique. Here, the rolling window technique may indicate a technique used to learn an AI model according to the order in which a plurality of reference data sets are acquired during a preset period.

When the model learning unit 148 learns the first AI model based on the rolling window technique, parameters of the first AI model are fine-tuned as the first AI model is sequentially learned according to the order in which the data sets have been acquired.

In one embodiment, the model learning unit 148 may learn the first AI model preferentially using a reference data set with the low degree of degradation. For example, the model learning unit 148 may learn the first AI model for a preset period, staring with a reference data set with the highest degree of degradation and finally using a reference data set with the lowest degree of degradation.

The model learning unit 148 may learn the first AI model to reduce a difference between pre-stored actual performance and predicted performance. The model learning unit 148 may learn the first AI model to reduce a difference between actual performance and predicted performance for each preset period based on the rolling window technique. Here, the actual performance may be actual performance of the first component according to the degree of degradation. The predicted performance may be data predicting the performance of the first component, which is output through the first AI model. For example, when the first component is a motor with 50% degradation and the predicted performance for the motor, which has been predicted from the first AI model is 30%, the model learning unit 148 may learn the first AI model so that the predicted performance converges to 50% through the learning for the remaining period of the preset period.

In one embodiment, the model learning unit 148 may learn the first AI model to output a probability value expressing failure or normality based on the reference data sets. For example, when failure is 0 and normality is 1, the first AI model may be learned to output 0.5 with respect to the motor with 50% degradation.

### Method of learning second AI model

The model learning unit 148 may learn the second AI model. The model learning unit 148 may learn the second AI model using learning data sets. Here, the learning data sets may be generated based on performance data of components with clear failure criteria or replacement time.

The model learning unit 148 may validate the second AI model based on the k-fold cross validation technique. The model learning unit 148 may validate the second AI model using validation data sets based on the k-fold cross validation technique. The model learning unit 148 may use the k-fold cross validation to validate whether the average solution performance of the second AI model is greater than or equal to pre-stored required performance. Here, the k-fold cross validation technique may be a technique of dividing the validation data set into k (k is a natural number of 2 to more) folds, selecting (k-1) training data sets and one validation data set among the data sets, and performing cross validation k times with respect to the AI model. The solution average performance may be average performance for the results of k cross validations by the k-fold cross validation technique.

The model learning unit 148 may learn the second AI model so that the average solution performance of the second AI model is greater than or equal to the required performance. When the average solution performance is smaller than the pre-stored required performance as a result of k-fold cross validation, the model learning unit 148 may construct the second AI model based on the result of validation. When the solution average performance is smaller than the pre-stored required performance as a result of k-fold cross validation, the model learning unit 148 may construct the second AI model of which the solution average performance satisfies the pre-stored required performance. Here, the required performance may be a target value of accuracy with which the second AI model predicts whether the second component fails. The solution average performance may be the average of k validation results by the k-fold cross validation.

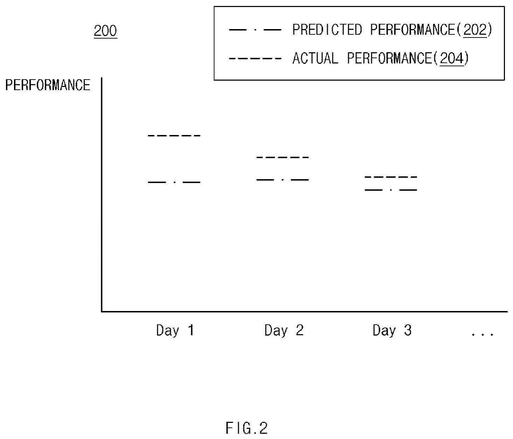

FIG. 2 shows a graph 200 of the result of learning the first AI model using the plurality of reference data sets which reflect degradation over time according to one embodiment of the present disclosure.

Referring to FIG. 2, the model learning unit 148 may compare predicted performance 202 of the first component, which has been predicted from the first AI model based on the result graph 200, with actual performance 204 thereof. Here, the predicted performance 202 may be the performance of the first component, which has been predicted according to the temporal degradation degree of the first component using the first AI model. The actual performance 204 may be actual performance of the first component in a degraded state.

The model learning unit 148 may learn the first AI model to reduce a difference between the predicted performance 202 and the actual performance 204 as a preset period lapses based on the rolling window technique.

Referring to the result graph 200, it can be seen that the difference between the predicted performance 202 and the actual performance 204 is reduced as the learning period elapses.

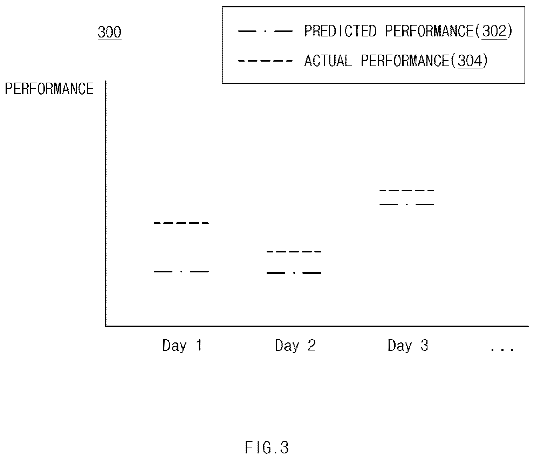

FIG. 3 shows a result graph 300 in which the first AI model has been learned using the plurality of reference data sets which reflect degradation according to a driving environment according to one embodiment of the present disclosure.

Referring to FIG. 3, predicted performance 302 of the first component, which has been predicted from the first AI model based on the result graph 300, with actual performance 304 thereof may be compared. Here, the predicted performance 302 may be the performance of the first component, which has been predicted according to the driving environmental degradation of the first component using the first AI model. The actual performance 304 may be actual performance of the first component in a degraded state.

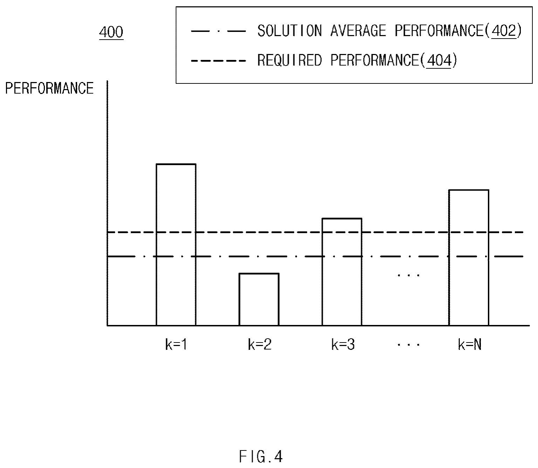

In FIGS. 3 and 4, although the result in which the model learning unit 148 has learned the first AI model using the plurality of reference data sets according to the temporal degradation or driving environmental degradation has been described, the model learning unit 148 may learn the first AI model using the plurality of reference data sets which reflect both the temporal degradation and driving environmental degradation. For example, the plurality of reference data sets may be generated by dividing a level of the degree of degradation into 10 levels, dividing a level of the driving environment into 10 levels, and arbitrarily combining the levels of the degree of degradation and the levels of the driving environment.

FIG. 4 shows a result graph 400 in which a second AI model has been cross-validated according to a k-fold cross validation technique according to one embodiment of the present disclosure.

Referring to FIG. 4, it can be seen that the solution average performance 402 is smaller than the required performance 404. Here, the solution average performance 402 may be an average of performance values when k is 1 to N (N is a natural number of 2 or more). The required performance 402 may be prediction accuracy required for the second AI model for predicting the replacement time of the second component.

When the solution average performance 402 is smaller than the required performance 404, the model learning unit 148 may generate new learning data sets based on the result of validation.

The model learning unit 148 may learn the second AI model using the new learning data sets. When the solution average performance 402 is smaller than the required performance 404, the model learning unit 148 may generate the new learning data sets until the solution average performance 402 satisfies the required performance 404 and learn the second AI model.

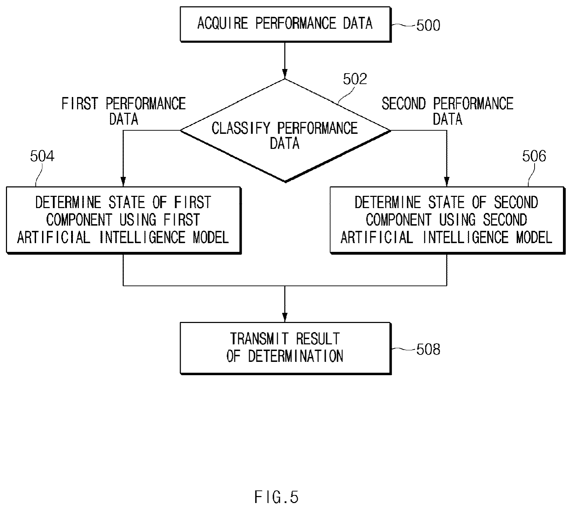

FIG. 5 is a flowchart showing a method of operating an apparatus for determining a state of a component according to one embodiment of the present disclosure.

Referring to FIG. 5, in operation 500, the data acquisition unit 142 may acquire the performance data. The data acquisition unit 142 may acquire the performance data through the communication circuit 100. The data acquisition unit 142 may acquire performance data about one or more components included in the electronic device 12. The data acquisition unit 142 may acquire performance data about the one or more components included in the electronic device 12 through the communication circuit 100.

In operation 502, the data extraction unit 144 may extract specific data among the performance data. The data extraction unit 144 may classify the performance data according to preset items to extract the specific data. The data extraction unit 144 may classify the performance data into first performance data or second performance data according to the type of component to extract data of a specific item. The data extraction unit 144 may extract the first performance data among the performance data. The data extraction unit 144 may extract the second performance data among the performance data.

In operation 504, the determination unit 146 may determine the state of the component. The determination unit 146 may determine the state of the component using a previously learned AI model. When the data extracted by the data extraction unit 144 is first performance data, the determination unit 146 may determine the state of the first component using the first AI model.

In operation 506, when the data extracted by the data extraction unit 144 is second performance data, the determination unit 146 may determine the state of the second component using the second AI model.

In operation 508, the result of determination of at least one of the state of the first component and the state of the second component determined by the determination unit 146 may be transmitted to the user terminal 14 through the communication circuit 100.

The terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed herein, and those skilled in the art to which embodiments disclosed herein pertain will be able to variously modify and change the present disclosure without departing from the essential characteristics of the embodiments disclosed herein. Therefore, the embodiments disclosed herein are not intended to limit the technical spirit disclosed herein, but for illustrative purpose, and the scope of the technical spirit disclosed herein is not limited by these embodiments. The scope of the technical spirit disclosed herein should be construed by the appended claims, and all technical spirits within the equivalent range should be construed as being included in the scope of this document.

## Claims

1. An apparatus for determining a state of a component, comprising:
a data acquisition unit configured to acquire performance data about one or more components included in an electronic device;
a data extraction unit configured to extract first performance data about a first component of which a replacement time has not been determined in advance among the performance data; and
a determination unit configured to determine a state of the first component using a pre-learned first artificial intelligence (AI) model based on the first performance data,
wherein the first AI model is learned based on a plurality of reference data sets according to a degree of degradation of the first component, and
wherein the first AI model is learned to reduce a difference between actual performance of the first component and predicted performance output from the first AI model.

2. The apparatus of claim 1, wherein the first AI model is learned sequentially using the plurality of reference data sets based on a rolling window technique.

3. The apparatus of claim 1, wherein the degree of degradation is set by at least one of a driving time and driving environment of the first component.

4. The apparatus of claim 1, wherein the data extraction unit further extracts second performance data of a second component of which a replacement cycle has been determined in advance among the performance data, and
the determination unit determines a state of the second component using a second AI model based on the second performance data.

5. The apparatus of claim 4, wherein the second AI model is learned so that solution average performance is greater than or equal to required performance based on performance evaluation by a k-fold cross validation technique.

6. A method of operating an apparatus for determining a state of a component, comprising:
an operation of acquiring performance data about one or more components included in an electronic device;
an operation of extracting first performance data about a first component of which a replacement time has not been determined in advance among the performance data; and
an operation of determining a state of the first component using a pre-learned first artificial intelligence (AI) model based on the first performance data,
wherein the first AI model is learned based on a plurality of reference data sets according to a degree of degradation of the first component, and
wherein the first AI model is learned to reduce a difference between actual performance of the first component and predicted performance output from the first AI model.

7. The method of claim 6, wherein the first AI model is learned sequentially using the plurality of reference data sets based on a rolling window technique.

8. The method of claim 6, wherein the degree of degradation is set by at least one of a driving time and driving environment of the first component.

9. The method of claim 6, further comprising:
an operation of extracting second performance data of a second component of which a replacement cycle has been determined in advance among the performance data; and
an operation of determining a state of the second component using a second AI model based on the second performance data.

10. The method of claim 9, wherein the second AI model is learned so that solution average performance is greater than or equal to required performance based on performance evaluation by a k-fold cross validation technique.
